# EUROPEAN PATENT SPECIFICATION

(11) **EP 3 373 109 B1**
(45) Date of publication and mention of the grant of the patent: **22.04.2020**
(21) Application number: 17160041.4
(22) Date of filing: 09.03.2017
(51) Int. Cl.: G06F 1/20

(54) **A THERMAL TRANSFER STRUCTURE, A METHOD, A MOBILE DEVICE AND THERMAL BATTERY**
WÄRMETRANSFERSTRUKTUR, VERFAHREN, MOBILE VORRICHTUNG UND WÄRME-AKKU
STRUCTURE DE TRANSFERT THERMIQUE, PROCÉDÉ, DISPOSITIF MOBILE ET BATTERIE THERMIQUE

(43) Date of publication of application: 12.09.2018
(73) Proprietor: Nokia Solutions and Networks Oy, 02610 Espoo (FI)
(72) Inventor: ENRIGHT, Ryan, Dublin 15 (IE)
(74) Representative: Bryers LLP

(56) References cited:
- EP-A2- 1 494 109
- US-A1- 2005 217 278
- US-A1- 2014 262 160

## Description

### TECHNICAL FIELD

Aspects relate, in general, to a thermal transfer structure, a method, a mobile device and thermal battery.

### BACKGROUND

In order to ensure reliable operation and prevent user injury, chip temperatures of mobile devices (e.g., smartphones, tablets and so on) can be maintained below a certain specified temperature (e.g. ∼85 °C). This boundary condition represents a significant thermal management challenge as device functionality and, hence, power dissipation continues to increase since current mobile devices typically rely on natural convection to the ambient and conduction heat transfer to the device user from the device skin.
It has been proposed to incorporate mini fans into mobile devices to increase convection heat transfer coefficients. However, such moving mechanical devices typically raise reliability concerns and they would draw power from the device battery. Another approach that has been suggested is the use of phase-change materials that undergo a solid to liquid transitions. Typical materials include paraffin wax, which can be tuned to have a melting temperature relevant for electronic thermal management (46 - 68 °C). However, these solutions are typically limited by the characteristically low latent heat of melting associated with these materials (*h*_{sf} ≈ 0.2 kJ/g) requiring large masses/volumes of material to make an appreciable impact on thermal performance.
US patent application US2014/262160A1 discloses an apparatus for managing heat generated by at least one electronic component of a mobile device.

### SUMMARY

According to an example, there is provided a thermal transfer structure for a mobile device, the structure comprising a heat pump, an evaporator chamber and a valve being in fluid communication with the evaporator chamber, the evaporator chamber comprising a vapour space and a liquid charge storage structure and wherein the valve is configured to control vapour mass flow rates from/to the evaporator chamber to/from the ambient environment. The heat pump can be a solid state heat pump, such as a thin-film thermoelectric heat pump or electrocaloric heat pump. The liquid charge storage structure can comprise a wicking structure to retain the liquid charge by way of capillary forces. The thermally conductive layer can be a heat plate thermally coupled to one or more heat sources of the mobile device. A temperature sensor can be provided, which is configured to generate a feedback control signal for the heat pump and valve. The valve can comprise a filter.

According to an example, there is provided a method for transferring heat from a heat source in a mobile device using evaporative cooling, the method comprising using a temperature sensor, generating a feedback control signal for a heat pump interposed between a thermally conductive layer and an evaporator chamber, the evaporator chamber comprising a vapour space and a liquid charge storage structure and being in fluid communication with a valve configured to control vapour mass flow rates from/to the evaporator chamber to/from the ambient environment and using the valve to vent liquid vapour from the evaporator chamber to the ambient environment on the basis of the feedback control signal. The method can further comprise selecting a volume for the liquid charge storage structure on the basis of a battery energy capacity of the mobile device. The method can further comprise charging the liquid charge storage structure using the heat pump by opening the valve and reducing the temperature of the evaporator chamber whereby to condense ambient water vapour in the evaporator chamber. The method can further comprise opening the valve when the feedback control signal indicates that a mobile device operation temperature exceeds a predetermined threshold value. The method can further comprise modifying the feedback control signal using data from a power management system of the mobile device and/or data representing ambient conditions in a location local to the mobile device.

According to an example, there is provided a mobile device comprising a thermal transfer structure, the structure comprising a heat pump, an evaporator chamber and a valve being in fluid communication with the evaporator, the evaporator chamber comprising a vapour space, a liquid charge storage structure and the valve being configured to control vapour mass flow rates from/to the evaporator chamber to/from the ambient environment, wherein the valve is in fluid communication with the ambient environment through a casing of the mobile device. The thermal transfer structure can further comprise a temperature sensor configured to generate a feedback control signal for the heat pump and valve representing an operating temperature of the mobile device. The volume of the liquid charge storage structure can be selected according to a battery energy capacity of the mobile device.

According to an example, there is provided a thermal battery for use in a mobile device, the thermal battery comprising a heat pump and an evaporator chamber, the evaporator chamber comprising a vapour space and a liquid charge storage structure and a valve being in fluid communication with the evaporator and configured to control vapour mass flow rates from/to the evaporator chamber to/from the ambient environment.

### BRIEF DESCRIPTION OF THE DRAWINGS

Embodiments will now be described, by way of example only, with reference to the accompanying drawings, in which:
Figure 1 is a schematic representation of part of a mobile device according to an example;
Figure 2 is a schematic representation of thermal transfer structure according to an example; and
Figure 3 is a schematic representation of a mobile device according to an example.

### DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

To maximize the effectiveness of thermal management, a device designer needs to ensure uniform spreading of heat to the device skin to maximize power dissipation levels while staying below a critical temperature such as that outlined above. This can be achieved using solid conduction spreader plates and, more recently, low profile vapor chambers. However, overall device performance and functionality is limited by periods of elevated computation where power dissipation levels peak and temperatures can exceed critical levels. This typically arises due to the limitations in the heat dissipation performance to the ambient and the user due to low heat transfer coefficients and ultimately, this poor thermal performance limits mobile device functionality. As heat transfer mechanisms may become increasingly unable to manage peak loads during mobile device operation, situations can arise where device power dissipation must be restricted leading to reduced functionality which impacts user experience.

According to an example, a heat transfer mechanism capable of handling peak power dissipation levels in mobile devices is provided. That is, an effective heat flow path is provided that can be used in parallel with or in place of existing heat management techniques. In an example, water evaporation is used as a heat transfer mechanism. Due to water's large latent heat of vaporization (hfg = 2.26 kj/g, which is ∼11x larger than paraffin), large amounts of thermal energy can be dissipated using a small mass of water that evaporates to the ambient environment. Thus, according to an example, a thermal transfer structure can be incorporated into a mobile device and used as an effective heat removal mechanism to handle peak dissipation loads while complimenting (or even replacing) existing thermal management systems.

In an example, such a system operates as a thermal battery. That is, during operation, liquid, such as water, can evaporate to the ambient environment through, for example, a vent in the skin of a mobile device, carrying away thermal energy via a mass transfer mechanism. This can be in parallel to a typical convection/conduction mechanism. Since the capacity of such an evaporator is finite, it can therefore be periodically charged with water. In an example, as it would be inefficient to allow water to continuously evaporate during device operation when an existing thermal solution can be sufficient for cooling, i.e., avoid device overcooling, an evaporation control mechanism can be employed so that the evaporator is used only when needed.

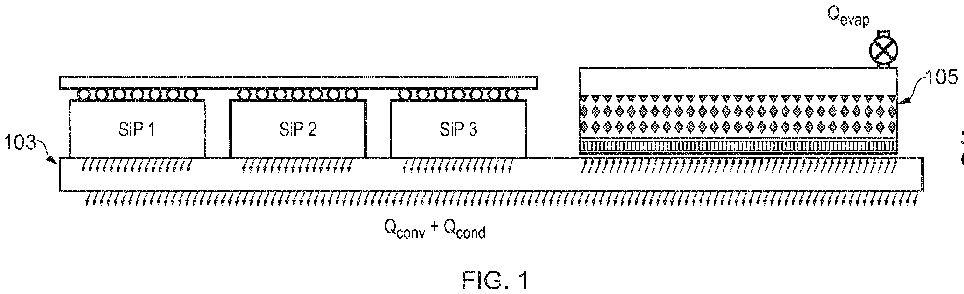

Figure 1 is a schematic representation of part of a mobile device according to an example. More particularly, figure 1 depicts part of a mobile device in which multiple system-in-package (SiP(s)) electronic components (SiP 1, SiP 2 and SiP 3) are provided in thermal contact, i.e. thermally connected, to a heat spreader 103. A thermal transfer structure 105 is also thermally connected to the heat spreader 103. The heat spreader 103 can be in the form a plate for example, which may be metallic.

The SiPs are heat sources of the mobile device. Heat generated by the SiPs flows into the spreader plate 103 and a proportion of the heat generated can be dissipated using the typical combination of conduction (Q_{cond}) and convection (Q_{conv}) from the skin of the mobile device. However, during peak heat dissipation periods for example, a thermal battery according to an example can be operated to remove excessive heat (Qₑᵥₐₚ) via evaporation of a liquid charge stored in the thermal transfer structure 105. The thermal transfer structure 105 architecture can be designed to maximize available volume within the mobile device by utilising empty space, which space can be used as part of a repository for liquid and/or as part of an evaporation chamber of the structure for example. As can be seen from the direction of the arrows in figure 1, which represent a flow of heat within the structure, heat dissipates from the SiPs to the plate 103 and from there to the ambient. However, the plate can also transfer heat to the structure 105 as shown.

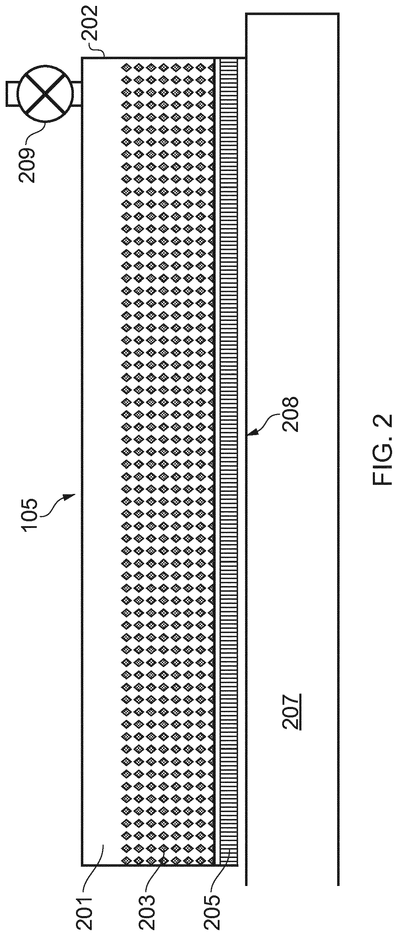

Figure 2 is a schematic representation of thermal transfer structure according to an example. More specifically, figure 2 depicts the thermal transfer structure 105 of figure 1 in more detail. In an example, the structure 105 within the mobile device is comprised of a vapour space 201 in the vicinity of a liquid wick structure 203 where a liquid charge is stored. The liquid to be stored can be water for example. In an example, the liquid wick structure 203 uses capillary forces to hold the liquid charge in place. The vapour space and wick structure can be housed in a hermetically sealed container 202 forming an evaporator chamber. That is, in an example, the evaporator chamber is defined by a vapour space 201 and a liquid charge storage structure 203. In an alternative configuration (not shown), the vapour space can be separate from the wick structure with the two in fluid communication with one another.

According to an example, a solid-state heat pump (SSHP) 205, such as a thin-film thermoelectric heat pump or electrocaloric heat pump, can be interposed between the structure 105 and a heat spreader, e.g., a solid or a vapour chamber, 207 (depicted as 103 in figure 1). The SSHP 205 can primarily be used for evaporator charging, but may also be used for mobile device thermal management while the evaporator is discharging or to measure heat flux into the evaporator.

An electronically controlled valve 209 is provided to control vapour mass flow rates from/to the vapour space 201 to/from the ambient environment. The valve can open to the ambient via the skin or outer structure/case of the mobile device. At least one temperature measurement sensor 208 can provide a feedback control signal for the heat pump and valve.

According to an example, during operation (evaporator discharging) the valve 209 is opened to allow liquid, such as water, to evaporate. The evaporator saturation pressure/temperature is determined by the heat dissipated, the valve pressure drop and the external ambient water vapour pressure (relative humidity). Moreover, the water vapour saturation temperature can be kept low enough for safety having the analogy to mammal homeostasis via sweating.

In an example, the thermal transfer structure can access or otherwise utilise data derived from the power management sub-system of a mobile device and information regarding the ambient conditions in a user's location, such as through local weather services or building monitoring systems for example, in order to determine rules for the evaporator sub-system operation when mobile device temperatures reach pre-defined critical levels. Accordingly, in combination with local temperature feedback, this allows an efficient use of the evaporator charge, e.g., avoid device over cooling to extend lifetime of evaporator charge. Furthermore, this can allow, for example, emergency measures such as operating the SSHP in combination with the evaporator to achieve maximum cooling of mobile device before device shutdown due to overheating.

In an example, the amount of liquid charge volume is dictated by the energy capacity of the device battery and the required percentage of that energy that will be dissipated by the evaporator. As an example, consider a typical tablet device with a volume = 4,712 mL and whose battery stores 140 kJ electrical. If all of that energy was used to evaporate water, for example, near room temperature (∼20 °C), a water volume of 62 mL would be needed (∼1.3% of the total device volume). However, a large majority of the battery's energy dissipation occurs at relatively low power levels that can be handled by the typical modes of thermal management. Assuming that 10% of the stored electrical energy would need to be dissipated gives 6.2 mL or ∼0.13% of total device volume.

In order to charge the evaporator, e.g., during mobile device battery charging, the SSHP 205 is powered and the evaporator valve 209 is fully opened. The cold side (evaporator side) of the SSHP module 205 is brought below the local ambient dew point to condense ambient water vapour in the evaporator.

Continuing with the example above, if 6.2 mL of water are to be condensed in the evaporator, this would require ∼14 kJ, corresponding to a 3 hr charge at a rate of 1.3 W thermal (neglecting vapour transport limitations). Considering a COP (= Q/W) = 0.25 for the SSHP during charging (a conservative estimate), that corresponds to 5.2 W electrical power consumed over that charging period. In dry climates, most people charge their devices inside air-conditioned buildings where relative humidity levels are ∼50%. Also, condensation of water charge from the ambient water vapour is effectively a distillation process so that is inherently clean limiting the potential for contamination. In an example, a vent on the device skin could double as a filter in order to prevent dust from entering the evaporator.

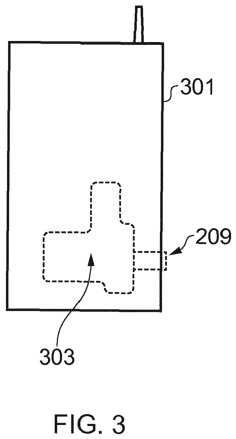

Figure 3 is a schematic representation of a mobile device according to an example. The device 301 includes a thermal transfer structure 303 as described above with reference to figures 1 and 2. Valve 209 can be seen with a portion protruding from the device 301 or otherwise able to vent to/from the ambient (for example, the valve inlet/outlet may be flush with the device casing/skin). As can be seen in figure 3, the shape of the structure 303 can be configured to utilise available space within the device 301.

Accordingly, an additional heat transfer path to complement existing natural convection and conduction modes of heat transfer in mobile devices is provided. It will draw little power compared to forced convection solutions while a device is operating, and can offer order of magnitude increase thermal dissipation density compared to existing solid-liquid phase change solutions, e.g., paraffin wax. The use of an SSHP to charge the evaporator is almost invisible to the mobile device user and can operate to charge the evaporator while the device battery is being charged.

The present inventions can be embodied in other specific apparatus and/or methods. The described embodiments are to be considered in all respects as illustrative and not restrictive. In particular, the scope of the invention is indicated by the appended claims rather than by the description and figures herein.

## Claims

1. A thermal transfer structure (105) for a mobile device, the structure comprising:
a heat pump (205), an evaporator chamber and a valve being in fluid communication with the evaporator chamber, the evaporator chamber comprising a vapour space (201) and a liquid charge storage structure and wherein the valve is configured to control vapour mass flow rates from/to the evaporator chamber to/from the ambient environment.

2. A thermal transfer (105) structure as claimed in claim 1, wherein the heat pump (205) is a solid state heat pump.

3. A thermal transfer structure (105) as claimed in claim 1 or 2, wherein the liquid charge storage structure comprises a wicking structure (203) to retain the liquid charge by way of capillary forces.

4. A thermal transfer structure (105) as claimed in any preceding claim, wherein the thermally conductive layer is a heat plate thermally coupled to one or more heat sources of the mobile device.

5. A thermal transfer structure (105) as claimed in any preceding claim, further comprising a temperature sensor (208) configured to generate a feedback control signal for the heat pump (205) and valve.

6. A thermal transfer structure (105) as claimed in any preceding claim, wherein the valve comprises a filter.

7. A method for transferring heat from a heat source in a mobile device using evaporative cooling, the method comprising:
using a temperature sensor (208), generating a feedback control signal for a heat pump (205) interposed between a thermally conductive layer and an evaporator chamber, the evaporator chamber comprising a vapour space (201) and a liquid charge storage structure and being in fluid communication with a valve configured to control vapour mass flow rates from/to the evaporator chamber to/from the ambient environment; and
using the valve to vent liquid vapour from the evaporator chamber to the ambient environment on the basis of the feedback control signal.

8. A method as claimed in claim 7, further comprising selecting a volume for the liquid charge storage structure on the basis of a battery energy capacity of the mobile device.

9. A method as claimed in claim 7 or 8, further comprising charging the liquid charge storage structure using the heat pump (205) by:
opening the valve; and
reducing the temperature of the evaporator chamber whereby to condense ambient water vapour in the evaporator chamber.

10. A method as claimed in any of claims 7 to 9, further comprising opening the valve when the feedback control signal indicates that a mobile device operation temperature exceeds a predetermined threshold value.

11. A method as claimed in any of claims 7 to 10, further comprising:
modifying the feedback control signal using data from a power management system of the mobile device and/or data representing ambient conditions in a location local to the mobile device.

12. A mobile device comprising a thermal transfer structure as claimed in any one of claims 1 to 6, wherein the valve is in fluid communication with the ambient environment through a casing of the mobile device.

13. A mobile device as claimed in claim 12, wherein the thermal transfer structure further comprises a temperature sensor (208) configured to generate a feedback control signal for the heat pump (205) and valve representing an operating temperature of the mobile device.

14. A mobile device as claimed in claim 12 or 13, wherein the volume of the liquid charge storage structure is selected according to a battery energy capacity of the mobile device.

15. A thermal battery for use in a mobile device, the thermal battery comprising:
a heat pump (205); and
an evaporator chamber, the evaporator chamber comprising a vapour space (201) and a liquid charge storage structure and a valve being in fluid communication with the evaporator chamber and configured to control vapour mass flow rates from/to the evaporator chamber to/from the ambient environment.

## Patentansprüche

1. Wärmeübertragungsstruktur (105) für ein Mobilgerät, wobei die Struktur Folgendes umfasst:
eine Wärmepumpe (205), eine Verdampferkammer und ein Ventil in Fluidverbindung mit der Verdampferkammer, wobei die Verdampferkammer einen Dampfraum (201) und eine Flüssigkeitsfüllung-Speicherstruktur umfasst und wobei das Ventil dafür gestaltet ist, Dampfdurchflussmengen von/zu der Verdampferkammer zu/von der Umgebung zu steuern.

2. Wärmeübertragungsstruktur (105) nach Anspruch 1, wobei die Wärmepumpe (205) eine Festkörper-Wärmepumpe ist.

3. Wärmeübertragungsstruktur (105) nach Anspruch 1 oder 2, wobei die Flüssigkeitsfüllung-Speicherstruktur eine Struktur mit Dochtwirkung (203) umfasst, um die Flüssigkeitsfüllung mittels Kappilarkräften zu halten.

4. Wärmeübertragungsstruktur (105) nach einem der vorhergehenden Ansprüche, wobei die thermisch leitende Schicht eine Wärmeplatte ist, die thermisch mit einer oder mehreren Wärmequellen des Mobilgeräts gekoppelt ist.

5. Wärmeübertragungsstruktur (105) nach einem der vorhergehenden Ansprüche, ferner einen Temperatursensor (208) umfassend, der dafür gestaltet ist, ein Rückkopplungs-Steuersignal für die Wärmepumpe (205) und das Ventil zu erzeugen.

6. Wärmeübertragungsstruktur (105) nach einem der vorhergehenden Ansprüche, wobei das Ventil einen Filter umfasst.

7. Verfahren zum Übertragen von Wärme von einer Wärmequelle in einem Mobilgerät mit Hilfe von Verdampfungskühlung, wobei das Verfahren Folgendes umfasst:
Verwenden eines Temperatursensors (208), der ein Rückkopplungs-Steuersignal für eine Wärmepumpe (205) erzeugt, die zwischen einer thermisch leitenden Schicht und einer Verdampferkammer eingesetzt ist, wobei die Verdampferkammer einen Dampfraum (201) und eine Flüssigkeitsfüllung-Speicherstruktur umfasst und mit einem Ventil in Fluidverbindung steht, das dafür gestaltet ist, Dampfdurchflussmengen von/zu der Verdampferkammer zu/von der Umgebung zu steuern, und
Verwenden des Ventils, um auf der Grundlage des Rückkopplungs-Steuersignals flüssigen Dampf von der Verdampferkammer an die Umgebung abzulassen.

8. Verfahren nach Anspruch 7, ferner das Auswählen eines Volumens für die Flüssigkeitsfüllung-Speicherstruktur auf der Grundlage einer Akkuenergiekapazität des Mobilgeräts umfassend.

9. Verfahren nach Anspruch 7 oder 8, ferner das Füllen der Flüssigkeitsfüllung-Speicherstruktur mit Hilfe der Wärmepumpe (205) durch Folgendes umfassend:
Öffnen des Ventils und
Verringern der Temperatur der Verdampferkammer, um dadurch Umgebungswasserdampf in der Verdampferkammer zu kondensieren.

10. Verfahren nach einem der Ansprüche 7 bis 9, ferner das Öffnen des Ventils umfassend, wenn Rückkopplungs-Steuersignals anzeigt, dass eine Mobilgerät-Betriebstemperatur einen festgelegten Grenzwert übersteigt.

11. Verfahren nach einem der Ansprüche 7 bis 10, ferner Folgendes umfassend:
Modifizieren des Rückkopplungs-Steuersignals mit Hilfe von Daten von einem Leistungsverwaltungssystem des Mobilgeräts und/oder Daten, die Umgebungsbedingungen an einem Standort des Mobilgeräts darstellen.

12. Mobilgerät, eine Wärmeübertragungsstruktur nach einem der Ansprüche 1 bis 6 umfassend, wobei das Ventil durch ein Gehäuse des Mobilgeräts hindurch in Fluidverbindung mit der Umgebung steht.

13. Mobilgerät nach Anspruch 12, wobei die Wärmeübertragungsstruktur ferner einen Temperatursensor (208) umfasst, der dafür gestaltet ist, ein Rückkopplungs-Steuersignal für die Wärmepumpe (205) und das Ventil zu erzeugen, das eine Betriebstemperatur des Mobilgeräts darstellt.

14. Mobilgerät nach Anspruch 12 oder 13, wobei das Volumen der Flüssigkeitsfüllung-Speicherstruktur gemäß einer Akkuenergiekapazität des Mobilgeräts ausgewählt wird.

15. Wärmeakku zur Verwendung in einem Mobilgerät, wobei der Wärmeakku Folgendes umfasst:
eine Wärmepumpe (205) und
eine Verdampferkammer, wobei die Verdampferkammer einen Dampfraum (201) und eine Flüssigkeitsfüllung-Speicherstruktur und ein Ventil in Fluidverbindung mit der Verdampferkammer umfasst, welches dafür gestaltet ist, Dampfdurchflussmengen von/zu der Verdampferkammer zu/von der Umgebung zu steuern.

## Revendications

1. Structure de transfert thermique (105) pour un dispositif mobile, la structure comprenant :
une pompe à chaleur (205), une chambre d'évaporation et une vanne qui est en communication fluidique avec la chambre d'évaporation, la chambre d'évaporation comprenant un espace de vapeur (201) et une structure de stockage de charge liquide, et la vanne étant configurée pour commander les débits massiques de vapeur depuis/vers la chambre d'évaporation vers/depuis l'environnement ambiant.

2. Structure de transfert thermique (105) selon la revendication 1, la pompe à chaleur (205) étant une pompe à chaleur à semi-conducteurs.

3. Structure de transfert thermique (105) selon la revendication 1 ou 2, la structure de stockage de charge liquide comprenant une structure à effet de mèche (203) pour retenir la charge liquide au moyen de forces capillaires.

4. Structure de transfert thermique (105) selon l'une quelconque des revendications précédentes, la couche thermiquement conductrice étant une plaque chauffante couplée thermiquement à une ou plusieurs sources de chaleur du dispositif mobile.

5. Structure de transfert thermique (105) selon l'une quelconque des revendications précédentes, comprenant en outre un capteur de température (208) configuré pour générer un signal de commande de rétroaction pour la pompe à chaleur (205) et la vanne.

6. Structure de transfert thermique (105) selon l'une quelconque des revendications précédentes, la vanne comprenant un filtre.

7. Procédé de transfert de chaleur à partir d'une source de chaleur dans un dispositif mobile utilisant un refroidissement par évaporation, le procédé comprenant :
l'utilisation d'un capteur de température (208), la génération d'un signal de commande de rétroaction pour une pompe à chaleur (205) interposée entre une couche thermiquement conductrice et une chambre d'évaporation, la chambre d'évaporation comprenant un espace de vapeur (201) et une structure de stockage de charge liquide, et étant en communication fluidique avec une vanne configurée pour commander les débits massiques de vapeur depuis/vers la chambre d'évaporation vers/depuis l'environnement ambiant ; et
l'utilisation de la vanne pour évacuer la vapeur de liquide de la chambre d'évaporation vers l'environnement ambiant sur la base du signal de commande de rétroaction.

8. Procédé selon la revendication 7, comprenant en outre la sélection d'un volume pour la structure de stockage de charge liquide sur la base d'une capacité d'énergie de batterie du dispositif mobile.

9. Procédé selon la revendication 7 ou 8, comprenant en outre la charge de la structure de stockage de charge liquide en utilisant la pompe à chaleur (205) par :
l'ouverture de la vanne ; et
la réduction de la température de la chambre d'évaporation afin de condenser la vapeur d'eau ambiante dans la chambre d'évaporation.

10. Procédé selon l'une quelconque des revendications 7 à 9, comprenant en outre l'ouverture de la vanne lorsque le signal de commande de rétroaction indique que la température de fonctionnement d'un dispositif mobile dépasse une valeur de seuil prédéterminée.

11. Procédé selon l'une quelconque des revendications 7 à 10, comprenant en outre :
la modification du signal de commande de rétroaction en utilisant des données provenant d'un système de gestion d'énergie du dispositif mobile et/ou des données représentant les conditions ambiantes dans un emplacement local au dispositif mobile.

12. Dispositif mobile comprenant une structure de transfert thermique selon l'une quelconque des revendications 1 à 6, la vanne étant en communication fluidique avec l'environnement ambiant à travers un boîtier du dispositif mobile.

13. Dispositif mobile selon la revendication 12, la structure de transfert thermique comprenant en outre un capteur de température (208) configuré pour générer un signal de commande de rétroaction pour la pompe à chaleur (205) et la vanne représentant une température de fonctionnement du dispositif mobile.

14. Dispositif mobile selon la revendication 12 ou 13, le volume de la structure de stockage de charge liquide étant sélectionné en fonction d'une capacité d'énergie de batterie du dispositif mobile.

15. Batterie thermique destinée à être utilisée dans un dispositif mobile, la batterie thermique comprenant :
une pompe à chaleur (205) ; et
une chambre d'évaporation, la chambre d'évaporation comprenant un espace de vapeur (201) et une structure de stockage de charge liquide et une vanne étant en communication fluidique avec la chambre d'évaporation et configurée pour commander les débits massiques de vapeur depuis/vers la chambre d'évaporation vers/depuis l'environnement ambiant.
